# EUROPÄISCHE PATENTANMELDUNG

(11) **EP 2 211 464 A1**
(43) Veröffentlichungstag der Anmeldung: **28.07.2010**
(21) Anmeldenummer: 09151322.6
(22) Anmeldetag: 26.01.2009
(51) Int. Cl.: H03K 6/04, H03K 5/06, H03K 17/16, H03K 19/003

(54) **Kommunikationsschaltung und Kommunikationsverfahren**

(71) Anmelder: Siemens Aktiengesellschaft, 80333 München (DE)
(72) Erfinder: Beyer, Stefan, 92263, Ebermannsdorf (DE)

(57) **Zusammenfassung**

Die Erfindung betrifft eine Schaltung zur Generierung von Rechteckimpulsfolgen als Sendesignal für eine Kommunikationsleitung welche Rechteckimpulsfolgen mit guten Flanken und guter elektromagnetischer Verträglichkeit generieren. Hierbei wird vorgeschlagen, dass die Schaltung umfasst:
- ein erstes Element, zum Schalten eines High Pegels auf der Kommunikationsleitung,
- ein zweites Element, zum Schalten eines Low Pegels auf der Kommunikationsleitung,
- eine Verarbeitungseinheit, welche durch Ansteuerung des ersten und zweiten Elements die Rechteckimpulsfolgen auf der Kommunikationsleitung erzeugen kann, und Empfangsmittel zum Empfangen von zur Schaltung gesandten Rechteckimpulsfolgen auf der Kommunikationsleitung aufweist,

wobei die Verarbeitungseinheit dazu eingerichtet ist, bei einer Schaltung eines Pegelwechsels von High Pegel auf Low Pegel oder von Low Pegel auf High Pegel mittels der Empfangsmittel einen die Flankensteigung des Pegelwechsels charakterisierenden Wert zu ermitteln und anhand des ermittelten Wertes das erste Element und/oder das zweite Element dahingehend einzustellen, dass bei einer erneuten Schaltung des Pegelwechsels eine erwünschte Flankensteigung auf der Kommunikationsleitung erreicht wird.

## Beschreibung

### Kommunikationsschaltung und Kommunikationsverfahren

Die Erfindung betrifft eine Schaltung zur Generierung von Rechteckimpulsfolgen als Sendesignal für eine Kommunikationsleitung.

Im Bereich der Automatisierungstechnik ist es häufig erwünscht, dass zwei Geräte miteinander kommunizieren können. Hierbei kann eine Kommunikation zwischen den Geräten beispielsweise mittels Rechteckimpulsfolgen auf einer Kommunikationsleitung erfolgen. Durch die Erzeugung der Rechteckimpulsfolgen wird auf der Kommunikationsleitung ein High Pegel und ein Low Pegel generiert. Hierdurch können unterschiedliche Zustände signalisiert und übertragen werden. Auf diese Weise kann eine Signalbildung und Signalübertragung auf der Kommunikationsleitung stattfinden. Durch eine hierfür vorgesehene Schaltung im Gerät kann das Sendesignal bzw. die Rechteckimpulsfolge auf der Kommunikationsleitung generiert und empfangen werden. Ein sogenannter Kommunikationsbaustein, beispielsweise ein Universal Asynchronous Receiver Transmitter (UART), wird hierfür in den Geräten implementiert. Mit Hilfe dieser Kommunikationsbausteine können sowohl eine Generierung von Rechteckimpulsen auf der Kommunikationsleitung erzeugt werden als auch auf der Kommunikationsleitung übertragene Rechteckimpulsfolgen empfangen werden. Somit kann mittels der Rechteckimpulsfolgen eine Kommunikation zwischen zwei Geräten über eine Kommunikationsleitung erfolgen.

Als problematisch hat sich dabei erwiesen, dass auf der Kommunikationsleitung Rechtecksignale generiert werden müssen. Hierbei werden über einen Spannungshub (High Pegel) und einen Spannungsabfall (Low Pegel) Flanken generiert. Solche Pegel auf der Leitung sind beispielsweise für Low Pegel: 0-8 Volt und für High Pegel: 13-30 Volt. Die Flankensteilheit beträgt für steigende und fallende Flanken 20% der Bitzeit, also z.B. T = 800ns. Um einen Low Pegel bzw. High Pegel auf der Kommunikationsleitung zu generieren, muss eine Leitung entsprechend aufgeladen bzw. entladen werden. Da eine Leitung zwischen den kommunizierenden Geräten entweder kurz oder lang sein kann bzw. eine unterschiedliche Beschaffenheit aufweisen kann, kann je nach verwendeter Leitung die elektrische Eigenschaft der gesamten Leitung variieren. Es kann der Widerstandsbelag R, der Ableitungsbelag G, der Kapazitätsbelag C und der Induktivitätsbelag L der gesamten Leitung variieren. Zusammengefasst kann gesagt werden, dass der Leitungsbelag bzw. der Leitungswellenwiderstand der gesamten Leitung je nach verwendeter Leitung unterschiedlich sein kann.

Die elektrische Eigenschaft der gesamten Leitung spiegelt sich jedoch enorm in der Flankensteigung und somit der Flankenqualität einer Rechteckimpulsfolge bei ihrem Pegelwechsel wieder. Ist bei einem Pegelwechsel die Flanke zu steil, so kann dies eine negative elektromagnetische Verträglichkeit (EMV) mit sich bringen. Ist dahingegen bei einem Pegelwechsel die Flanke zu flach, so kann dies problematisch für die Flankenerkennung der Rechteckimpulsfolge werden.

Da die Implementierung der Geräte in der Automatisierungstechnik je nach Anwendungsfall unterschiedlich ausfallen kann, werden für die Verkabelungen der Geräte unterschiedliche Leitungslängen benötigt. Bei der Herstellung dieser Geräte und folglich bei der Dimensionierung der Schaltung in dem Gerät kann somit noch nicht optimal auf die Länge und infolgedessen auf die letztendliche elektrische Eigenschaft der eingesetzten Leitung eingegangen werden. Somit muss die Schaltung bei der Herstellung einen Kompromiss hinsichtlich der Flankenqualität eingehen. Hierdurch ergeben sich für die erwünschte Signalqualität minimale und maximale Längen der zu verwendenden Leitungen.

Der Erfindung liegt die Aufgabe zugrunde, Rechteckimpulsfolgen mit guten Flanken und guter elektromagnetischer Verträglichkeit zu generieren.

Die Lösung der gestellten Aufgabe gelingt durch eine Schaltung zur Generierung von Rechteckimpulsfolgen als Sendesignal für eine Kommunikationsleitung, wobei die Schaltung umfasst:
- ein erstes Element, zum Schalten eines High Pegels auf der Kommunikationsleitung,
- ein zweites Element, zum Schalten eines Low Pegels auf der Kommunikationsleitung,
- eine Verarbeitungseinheit, welche durch Ansteuerung des ersten und zweiten Elements die Rechteckimpulsfolgen auf der Kommunikationsleitung erzeugen kann, und Empfangsmittel zum Empfangen von zur Schaltung gesandten Rechteckimpulsfolgen auf der Kommunikationsleitung aufweist,
wobei die Verarbeitungseinheit dazu eingerichtet ist, bei einer Schaltung eines Pegelwechsels von High Pegel auf Low Pegel oder von Low Pegel auf High Pegel mittels der Empfangsmittel einen die Flankensteigung des Pegelwechsels charakterisierenden Wert zu ermitteln und anhand des ermittelten Wertes das erste Element und/oder das zweite Element dahingehend einzustellen, dass bei einer erneuten Schaltung des Pegelwechsels eine erwünschte Flankensteigung auf der Kommunikationsleitung erreicht wird.

Ferner wird die Aufgabe gelöst durch ein Verfahren zur Generierung von Rechteckimpulsfolgen als Sendesignal für eine Kommunikationsleitung, wobei über ein erstes Element ein High Pegel auf der Kommunikationsleitung geschaltet wird, über ein zweites Element, ein Low Pegel auf der Kommunikationsleitung geschaltet wird, über eine Verarbeitungseinheit, durch Ansteuerung des ersten und zweiten Elements die Rechteckimpulsfolgen auf der Kommunikationsleitung erzeugen werden, und mittels Empfangsmittel von zur Schaltung gesandten Rechteckimpulsfolgen auf der Kommunikationsleitung empfangen werden, mit folgenden Verfahrensschritten:
- Ermittlung eines die Flankensteigung eines Pegelwechsels charakterisierenden Wertes
- Einstellen des ersten Elements und/oder des zweiten Elements anhand des ermittelten Wertes dahingehend, dass bei einer erneuten Schaltung des Pegelwechsels eine erwünschte Flankensteigung auf der Kommunikationsleitung erreicht wird.

Weitere vorteilhafte Ausführungsformen ergeben sich aus den Unteransprüchen.

Dadurch, dass die Schaltung während eines Sendevorgangs über die bereits vorhandenen Empfangsmittel eine qualitative Auswertung der Flankensteigung bei einem Pegelwechsel ermittelt, kann die Schaltung anhand des ermittelten Wertes positiv auf die Gestaltung künftiger Rechteckimpulsfolgen einwirken. Liegt beispielsweise eine zu steile Flanke vor, so sollte das erste Element bzw. das zweite Element dahingehend eingestellt werden, dass der Widerstand des ersten bzw. zweiten Elements größer wird und es somit zu einer flacheren Flanke kommt. Liegt dagegen eine zu flache Flanke vor, so sollte das erste bzw. zweite Element derart eingestellt werden, dass der Widerstand des ersten bzw. zweiten Elements kleiner wird und es somit zu einer steileren Flanke kommt.

Durch die Analyse und darauf folgende Beeinflussung des ersten bzw. zweiten Elements kann somit die Steigung der Flanke und somit die Flankenqualität beeinflusst und verbessert werden. Ziel ist es vornehmlich, eine konstante Zeit für einen Pegelwechsel auf der Kommunikationsleitung zu erreichen. Dadurch, dass das bei einem Sendevorgang üblicherweise inaktive Empfangsmittel für die qualitative Beurteilung des Sendesignals bei der vorliegenden Erfindung aktiv den Pegelwechsel detektiert, kann eine enorme Verbesserung der Signalqualität erzielt werden. Hierbei ist es vor allem vorteilhaft, dass die bereits vorhandenen erforderlichen Komponenten einer Kommunikationsschaltung genutzt werden, um die interne Analyse des Sendesignals durchzuführen und daraufhin derart einzuwirken, um eine verbesserte Signalqualität zu erzielen. Durch eine solche Schaltung kann somit aktiv auf den Leitungstyp bzw. auf die Länge der verwendeten Datenleitung eingewirkt werden. Auf diese Weise vergrößert die erfindungsgemäße Schaltung das Einsatzspektrum herkömmlicher Schaltungen und verbessert dabei gleichzeitig die Qualität der generierten Rechteckeimpulsfolgen. Hierdurch können Geräte mit einer besseren Qualität und einer größeren Reichweite angeboten werden.

In einer Ausführungsform der Erfindung stellt der die Flankensteigung des Pegelwechsels charakterisierende Wert ein gemessenes Zeitintervall für einen definierten Spannungsanstieg oder Spannungsabfall auf der Kommunikationsleitung dar.

Auf diese Weise kann je nach Kommunikationssignal ein bei einem Pegelwechsel für die Flankensteigung charakterisierender Wert ermittelt werden und weiter bewertet werden. Je nachdem wie groß das Band eines High Pegels bzw. das eines Low Pegels ist, kann ein definierter Spannungswert für einen Spannungsabfall bzw. für einen Spannungsanstieg eingestellt werden. Tritt nun ein Pegelwechsel auf, so wird die Zeit genommen, die die Kommunikationsleitung benötigt um von dem High Pegel zu dem Low Pegel zu kommen oder umgekehrt. Anhand dieses ermittelten Wertes kann eine quantitative Beurteilung der Flankensteigung generiert werden. Dies kann durch den reinen Zeitwert des Pegelwechsels erfolgen aber auch durch die ermittelte Steigung der Rechteckimpulsfolge bei dem Pegelwechsel. Die Beschränkung der Analyse auf einen Abschnitt des Pegelwechsels ist ebenso möglich.

In einer weiteren Ausführungsform der Erfindung weist die Verarbeitungseinheit einen Universal Asynchronous Receiver Transmitter (UART) auf.

Bei der Verwendung eines UARTs kann das vorhandene Empfangsmittel dahingehend genutzt werden, einen Pegelwechsel auf der Kommunikationsleitung zu verfolgen und somit eine Verbesserung der Flankenqualität nach den erfindungsgemäßen Schritten zu ermöglichen.

In einer weiteren Ausführungsform der Erfindung ist das Sendesignal für IO-Link ausgelegt.

Auf diese Weise kann der Radius der aus dem Stand der Technik bekannten IO-Link Kommunikation vergrößert werden und zudem die Signalqualität der aus dem Stand der Technik bekannten IO-Link Kommunikation verbessert werden.

In einer weiteren Ausführungsform der Erfindung weist die Verarbeitungseinheit einen CPLT (Complex Programmable Logic Device) oder FPGA (Field Programmable Gate Array) Baustein auf.

Auf diese Weise kann eine einfache Implementierung der erfindungsgemäßen Vorrichtung erfolgen.

In einer weiteren Ausführungsform der Erfindung weist das erste und/oder zweite Element einen Transistor, insbesondere einen MOSFET, auf.

Auf diese Weise kann das erste und/oder zweite Element optimal den Flankenanstieg bzw. Flankenabfall beeinflussen und somit auf die Qualität des Pegelwechsels einwirken.

In einer weiteren Ausführungsform der Erfindung weist das erste und/oder zweite Element einen einstellbaren Widerstand auf.

Durch den einstellbaren Widerstand kann die Flankensteigung einer Rechteckimpulsfolge beeinflusst werden. Bei vorliegen eines den Pegelwechsel charakterisierenden Wertes und somit eines quantitativen Wertes der Flankensteigung, kann der einstellbare Widerstand dahingegen eingestellt werden, dass ein qualitativ besseres Sendesignal auf der Kommunikationsleitung erzeugt wird.

Im Folgenden wird die Erfindung und Ausgestaltung der Erfindung anhand der in den Figuren dargestellten Ausführungsbeispiele näher beschrieben und erläutert. Es zeigen:
- FIG 1: eine Darstellung eines Aufbaus einer Kommunikati- onsanbindung zweier Geräte;
- FIG 2: einen Aufbau einer Schaltung mit einer angeschlos- senen Datenleitung;
- FIG 3: eine Ausführungsform der unter Figur 2 beschriebnen Schaltung;
- FIG 4: eine Darstellung eines Ablaufs eines Sendesignals und somit einer Rechteckimpulsfolge über die Zeit und
- FIG 5: eine Darstellung eines Übergangs von einem Sende- signal von High Pegel auf Low Pegel.

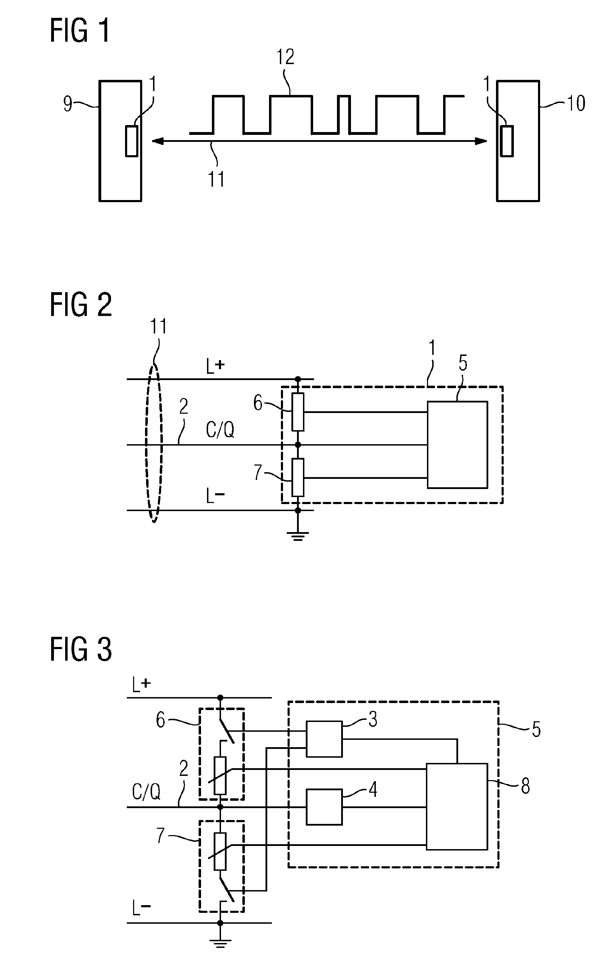

FIG 1 zeigt eine Darstellung eines Aufbaus einer Kommunikationsanbindung zweier Geräte 9, 10. Hierbei ist ein Master 9 mit einem Slave 10 über eine Datenleitung 11 verbunden. Der Master 9 weist eine Schaltung 1 zur Generierung und zum Empfangen von Rechteckimpulsfolgen 12 auf. Ebenso weist der Slave 10 eine Schaltung 1 zur Generierung und zum Empfangen von Rechteckimpulsfolgen 12 auf. Auf der Datenleitung 11 wird durch Generierung von High Pegel und Low Pegel eine Rechteckimpulsfolge 12 und somit ein Signal generiert. Diese Rechteckimpulsfolge 12 kann in der Schaltung 1 empfangen bzw. gesendet werden. Die Schaltung 1 kann beispielsweise durch ein UART realisiert sein.

FIG 2 zeigt einen Aufbau einer Schaltung 1 mit einer angeschlossenen Datenleitung 11. Hierbei besteht die Datenleitung 11 aus einer Kommunikationsleitung 2 und zwei Versorgungsleitungen L+ und L-. L+ dient hierbei der Generierung eines High Pegels auf der Kommunikationsleitung 2. L- dient der Generierung eines Low Pegels auf der Kommunikationsleitung 2. Über das erste Element 6 kann die Versorgungsleitung L+ mit der Kommunikationsleitung 2 verbunden werden. Wird die Versorgungsleitung L+ mit der Kommunikationsleitung 2 verbunden, so erfolgt ein Spannungsanstieg auf der Kommunikationsleitung 2. Es entsteht ein High Pegel auf der Kommunikationsleitung 2. Wird nun das erste Element 6 geöffnet, so dass keine Verbindung zwischen der Kommunikationsleitung 2 und der Versorgungsleitung L+ besteht und das zweite Element 7 geschlossen, so dass die Kommunikationsleitung mit der Versorgungsleitung L- verbunden ist, so erfolgt ein Spannungsabfall. Es entsteht ein Low Pegel auf der Kommunikationsleitung 2. Ein Übergang von einem High Pegel auf einen Low Pegel wird als Pegelwechsel bezeichnet. Ein solcher Pegelwechsel weist somit eine Flanke auf. Je nach dem wie schnell bzw. wie langsam der Pegelwechsel auf der Kommunikationsleitung 2 erfolgt, desto steiler bzw. flacher ist die Flanke der Rechteckimpulsfolge. Durch das Schalten von High Pegel auf Low Pegel und umgekehrt kann eine Kommunikation auf der Kommunikationsleitung 2 mit einem angeschlossenen Gerät erfolgen. Bei einer solchen Kommunikation werden somit zwischen zwei Geräten mit Hilfe von Rechteckimpulsfolgen Signale ausgetauscht.

Das Senden und Empfangen von Rechteckimpulsfolgen und somit von Signalen wird durch die Schaltung 1 realisiert. Die Schaltung 1 weist ein erstes Element 6, ein zweites Element 7 und eine Verarbeitungseinheit 5 auf. Mit Hilfe der Verarbeitungseinheit 5 können das erste Element 6 und das zweite Element 7 angesteuert werden. Des Weiteren weist die Verarbeitungseinheit 5 geeignete Mittel auf, um Rechteckimpulsfolgen auf der Kommunikationsleitung 2 zu detektieren. Mit diesen Empfangsmitteln kann die Verarbeitungseinheit 5 einen Übergang von einem High Pegel Signal auf einen Low Pegel Signal oder umgekehrt feststellen.

Soll beispielesweise auf der Kommunikationsleitung 2 ein High Pegel generiert werden, so steuert die Verarbeitungseinheit 5 das erste Element 6 derart an, so dass die Versorgungsleitung L+ mit der Kommunikationsleitung 2 verbunden wird. Es wird ein High Pegel erzeugt. Mit Hilfe der in der Verarbeitungseinheit 5 befindlichen Empfangsmittel kann der Spannungsanstieg auf der Kommunikationsleitung 2 nachverfolgt werden. Somit kann die Geschwindigkeit bis zur Erreichung des High Pegels auf der Kommunikationsleitung 2 ermittelt werden. Liegt ein High Pegel vor, so kann durch Öffnen des ersten Elements 6 und Schließen des zweiten Elements 7 ein Low Pegel auf der Kommunikationsleitung 2 erzeugt werden. Mit Hilfe der in der Verarbeitungseinheit 5 befindlichen Empfangsmittel kann der Übergang vom High Pegel zum Low Pegel beobachtet werden. Somit kann die Geschwindigkeit bis zur Erreichung des Low Pegels auf der Kommunikationsleitung 2 ermittelt werden. Anhand der ermittelten Werte kann somit die Geschwindigkeit des Pegelwechsels von High Pegel auf Low Pegel oder umgekehrt bewertet werden. Ist die Flanke beispielsweise zu flach, d.h. der Übergang war zu langsam, so kann durch Verkleinerung des Widerstandes des jeweiligen Elements 6, 7 ein schnellere Pegelwechsel erzielt werden; die Flankensteigung steigt. Ist dagegen die Flanke zu steil, d.h. der Übergang war zu schnell, so kann durch Vergrößerung des Widerstandes des jeweiligen Elementes 6, 7 der Pegelwechsel verlangsamt werden; die Flankensteigung sinkt.

Durch das aktive Beobachten des Pegelwechsels bzw. der Geschwindigkeit eines Pegelwechsels auf der Kommunikationsleitung 2 durch die Empfangsmittel der Verarbeitungseinheit 5 kann mit Hilfe des ersten und zweiten Elements 6, 7 die Flankensteigung dahingehend beeinflusst werden, dass eine optimale Signalübertragung auf der Kommunikationsleitung 2 stattfinden kann. Somit kann eine konstante Zeit für einen Pegelwechsel auf der Kommunikationsleitung 2 mit Hilfe des ersten und zweiten Elements 6, 7 eingestellt werden.

FIG 3 zeigt eine Ausführungsform der unter Figur 2 beschriebnen Schaltung 1. Hierbei ist eine Ausführungsform des ersten und zweiten Elements 6 und 7 näher visualisiert. Es wird ersichtlich, dass das erste und zweite Element 6, 7 jeweils die Funktion eines Schalters und eines einstellbaren Widerstandes erfüllen muss. Dies kann beispielsweise durch einen Halbleiter-Schaltelement wie ein MOSFET realisiert werden. Des Weiteren wird ersichtlich, dass die Verarbeitungseinheit 5 ein Sendemittel 3 und ein Empfangsmittel 4 sowie einen Microcontroller 8 aufweist. Mit Hilfe des Sendemittels 3 werden das erste Element 6 und das zweite Element 7 angesteuert. Mit Hilfe des Empfangsmittels 4 kann eine Rechteckimpulsfolge auf der Kommunikationsleitung 2 detektiert werden. Das Empfangsmittel 4 kann somit einen Spannungshub bzw. einen Spannungsabfall auf der Kommunikationsleitung 2 detektieren. Mit Hilfe des Microcontrollers 8 kann das Sendemittel 3 und das Empfangsmittel 4 angesteuert werden, sowie die durch das Empfangsmittel 4 empfangenen Daten verarbeitet werden.

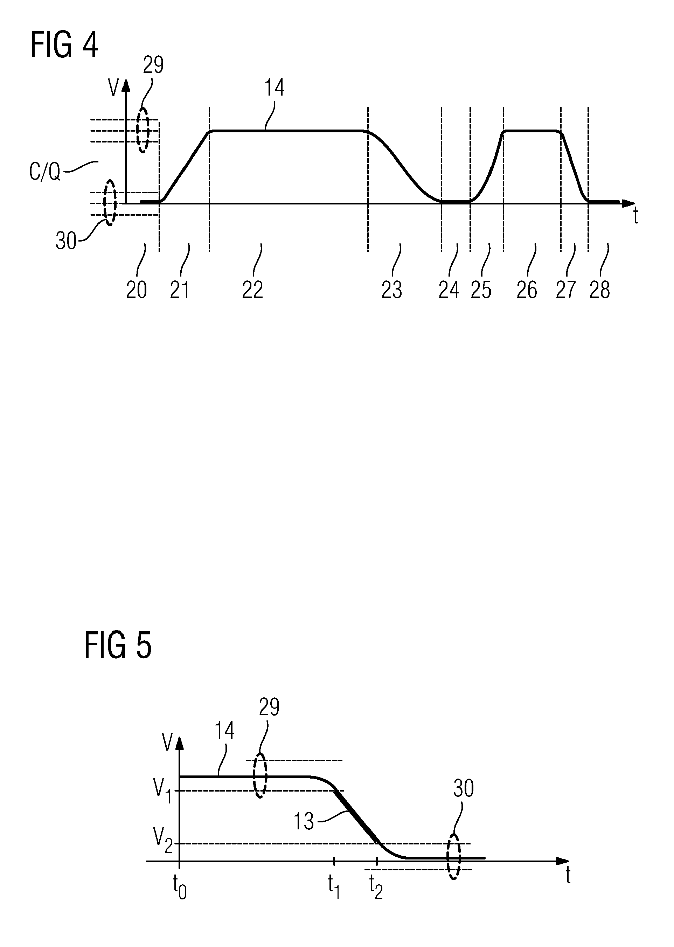

FIG 4 zeigt eine Darstellung eines Ablaufs eines Sendesignals 14 und somit einer Rechteckimpulsfolge über die Zeit t. Hierbei wird der Spannungsverlauf V einer Kommunikationsleitung C/Q über die Zeit t visualisiert. Ein Signal 14 weist zu unterschiedlichen Zeitpunkten einen unterschiedlichen Spannungswert auf. Die horizontale Achse visualisiert hierbei die Zeit t. Die vertikale Achse visualisiert hierbei den Spannungsverlauf V. Auf der vertikalen Achse ist jeweils der Bereich des High Pegels 29 sowie der Bereich des Low Pegels 30 ersichtlich. Hierbei ist meist kein fester Spannungswert zu verstehen sondern ein Band in dem sich das Signal 14 bewegen darf. Betrachtet man nun das Sendesignal 14 über den visualisierten Zeitverlauf so ist ersichtlich das dieses je nach Zeitfenster 20, 21, 22, 23, 24, 25, 26, 27, 28 unterschiedliche Pegel eingenommen hat. In der ersten Phase 20 liegt für das Sendesignal 14 ein Low Pegel vor. In der zweiten Phase 21 findet ein Pegelwechsel von Low Pegel auf High Pegel statt. In der dritten Phase 23 liegt ein High Pegel für das Sendesignal 14 vor. In der vierten Phase 23 findet ein Pegelwechsel von High Pegel auf Low Pegel statt. In der fünften Phase 24 liegt ein Low Pegel vor. In der sechsten Phase 25 findet ein Pegelwechsel von Low Pegel auf High Pegel statt. In der siebten Phase 26 liegt ein High Pegel vor und in der achten Phase 27 findet wiederum ein Pegelwechsel von High Pegel auf Low Pegel statt, so dass in der neunten Phase 28 ein Low Pegel vorliegt.

FIG 5 zeigt eine Darstellung eines Übergangs von einem Sendesignal 14 von High Pegel 29 auf Low Pegel 30. Auf der vertikalen Achse ist der Spannungsbereich dargestellt, in dem das Sendesignal 14 ein High Pegel Signal 29 darstellt und ein Low Pegel Signal 30 darstellt. Hier ist eine Spannungsgrenze V1 dargestellt. Oberhalb dieser Spannungsgrenze V1 liegt ein High Pegel Signal 29 vor und unterhalb der Spannungsgrenze V2 liegt ein Low Pegel Signal 30 vor. Findet nun ein Wechsel des Sendesignals 14 vom High Pegel 29 auf Low Pegel 39 statt, so ist der Bereich der zwischen dem Spannungswert V1 und V2 liegt der Bereich des Pegelwechsels 13. Ziel ist es, die Zeitdauer eines Pegelwechsels konstant zu halten und derart einzustellen, dass eine bestimmte Zeit t2 - t1 benötigt wird. Findet ein zu schneller Pegelwechsel 13 statt, so dass der Wert t2 - t1 sehr klein ist, so kann dies negative Auswirkungen bezüglich der elektromagnetischen Verträglichkeit mit sich bringen. Ist die Zeit des Pegelwechsels 13 jedoch sehr lange, so dass der Wert t2 - t1 sehr groß ist, so kann dies eine verschliffene Flanke zu Folge haben und somit Kommunikationsprobleme hervorrufen. Ziel ist es somit je nach Anwendungsfall eine bestimmte Zeitdauer t2 - t1 des Pegelwechsels 13 aufzuweisen. Der Wert t2 - t1 und somit die Zeitdauer eines Pegelwechsels 13 gibt somit Aufschluss über die Signalqualität des Sendesignals 14. Anhand der Zeitdauer eines Pegelwechsels 13 und der High Pegel Schwelle V1 und Low Pegel Schwelle V2 kann die Steigung des Pegelwechsels 13 ermittelt werden. Mit Hilfe dieser Steigung kann ebenso eine qualitative Aussage über das Sendesignal 14 getätigt werden.

## Patentansprüche

1. Schaltung (1) zur Generierung von Rechteckimpulsfolgen (12) als Sendesignal (14) für eine Kommunikationsleitung (2), wobei die Schaltung (1) umfasst:
- ein erstes Element (6), zum Schalten eines High Pegels (29) auf der Kommunikationsleitung (2),
- ein zweites Element (7), zum Schalten eines Low Pegels (30) auf der Kommunikationsleitung (2),
- eine Verarbeitungseinheit (5), welche durch Ansteuerung des ersten und zweiten Elements (6,7) die Rechteckimpulsfolgen (12) auf der Kommunikationsleitung (2) erzeugen kann, und Empfangsmittel (4) zum Empfangen von zur Schaltung gesandten Rechteckimpulsfolgen (12) auf der Kommunikationsleitung (2) aufweist,
wobei die Verarbeitungseinheit (5) dazu eingerichtet ist, bei einer Schaltung eines Pegelwechsels (13) von High Pegel (29) auf Low Pegel (28) oder von Low Pegel (28) auf High Pegel (29) mittels der Empfangsmittel (4) einen die Flankensteigung des Pegelwechsels (13) charakterisierenden Wert zu ermitteln und anhand des ermittelten Wertes das erste Element (6) und/oder das zweite Element (7) dahingehend einzustellen, dass bei einer erneuten Schaltung des Pegelwechsels (13) eine erwünschte Flankensteigung auf der Kommunikationsleitung (2) erreicht wird.

2. Schaltung nach Anspruch 1,
wobei der die Flankensteigung des Pegelwechsels (13) charakterisierende Wert ein gemessenes Zeitintervall für einen definierten Spannungsanstieg oder Spannungsabfall auf der Kommunikationsleitung darstellt.

3. Schaltung nach einen der vorhergehenden Ansprüche,
wobei die Verarbeitungseinheit (5) einen Universal Asynchronous Receiver Transmitter (UART) aufweist.

4. Schaltung nach einen der vorhergehenden Ansprüche,
wobei das Sendesignal (14) für IO-Link ausgelegt ist.

5. Schaltung nach einen der vorhergehenden Ansprüche,
wobei die Verarbeitungseinheit (5) einen CPLD oder FPGA Baustein aufweist.

6. Schaltung nach einen der vorhergehenden Ansprüche,
wobei das erste und/oder zweite Element (6,7) einen Transistor, insbesondere einen MOSFET, aufweist.

7. Schaltung nach Ansprüche 6,
wobei das erste und/oder zweite Element (6,7) einen einstellbaren Widerstand aufweist.

8. Verfahren zur Generierung von Rechteckimpulsfolgen (12) als Sendesignal (14) für eine Kommunikationsleitung (2), wobei über ein erstes Element (6) ein High Pegel (29) auf der Kommunikationsleitung (2) geschaltet wird, über ein zweites Element (7), ein Low Pegel (30) auf der Kommunikationsleitung (2) geschaltet wird, über eine Verarbeitungseinheit (5), durch Ansteuerung des ersten und zweiten Elements (6,7) die Rechteckimpulsfolgen (12) auf der Kommunikationsleitung (2) erzeugen werden, und mittels Empfangsmittel (4) von zur Schaltung gesandten Rechteckimpulsfolgen (12) auf der Kommunikationsleitung (2) empfangen werden,
mit folgenden Verfahrensschritten:
- Ermittlung eines die Flankensteigung eines Pegelwechsels (13) charakterisierenden Wertes
- Einstellen des ersten Elements (6) und/oder des zweiten Elements (7) anhand des ermittelten Wertes dahingehend, dass bei einer erneuten Schaltung des Pegelwechsels (13) eine erwünschte Flankensteigung auf der Kommunikationsleitung (2) erreicht wird.

9. Verfahren nach Anspruch 8,
wobei der die Flankensteigung des Pegelwechsels (13) charakterisierende Wert durch eine Messung eines Zeitintervalls für einen definierten Spannungsanstieg oder Spannungsabfall auf der Kommunikationsleitung (2) ermittelt wird.

10. Verfahren nach Anspruch 9,
wobei das Sendesignal (14) für IO-Link verwendet wird.

11. Verfahren nach Anspruch 10,
wobei das erste und/oder zweite Element (6,7) über einen Transistor, insbesondere einen MOSFET, und/oder einen einstellbaren Widerstand eingestellt wird.
